# DEMANDE DE BREVET EUROPEEN

(11) **EP 4 199 665 A2**
(43) Date de publication de la demande: **21.06.2023**
(21) Numéro de dépôt: 22214345.5
(22) Date de dépôt: 16.12.2022
(51) Int. Cl.: H05K 7/14

(54) **MODULE DE TENSION POUR COFFRET DE DISTRIBUTION DE BASSE TENSION, ET COFFRET ASSOCIÉ**

(30) Priorité: 16.12.2021 FR 2113742
(71) Demandeur: Aures Technologies, 91090 Lisses (FR)
(72) Inventeur: HALNAIS, Pierre, 91090 Lisses (FR)
(74) Mandataire: Germain Maureau

(57) **Abrégé**

L'invention concerne, entre autres, un module de tension (10) pour coffret (100) de distribution de basse tension électrique, le module de tension (10) comprenant :
- un boitier (13) logeant :
o une unité (14) de conversion de tension DC-DC,
o un moyen de dissipation (15A, 15B) thermique associé à l'unité (14) de conversion de tension DC-DC,
caractérisé en ce que le boitier (13) a une largeur (E) égale à un multiple de deux pas, le multiple de deux pas étant compris entre deux pas et quarante-huit pas.

## Description

La présente invention concerne le domaine des modules de tension pour coffret de distribution de basse tension électrique. Elle concerne également le domaine des coffrets comprenant de tels modules, ainsi que des bornes interactives comprenant de tels coffrets.

L'invention trouve une application particulière dans le domaine des bornes interactives, sans toutefois se limiter à ce domaine. En l'occurrence, les modules de tension pour coffret de distribution de basse tension électrique et les coffrets associés peuvent être prévus pour équiper tout appareil électrique comprenant plusieurs sous-ensembles alimentés chacun par une basse tension différente.

On connaît, par exemple, les appareils électriques tels que les bornes interactives qui sont généralement alimenter par une prise secteur. Ces appareils électriques comprennent généralement plusieurs sous-ensembles électroniques tel un dispositif d'affichage, un dispositif d'impression, un dispositif de paiement, un dispositif de routage, un hub de connexion ou encore un dépileur de cartes, Chacun de ces dispositifs requiert une alimentation électrique basse tension adaptée pour son fonctionnement. Le besoin en tension peut varier d'un dispositif à l'autre. Par exemple, le dispositif d'affichage peut être un écran tactile nécessitant une alimentation basse tension de 19 Volts, alors que le dispositif d'impression nécessite une alimentation basse tension de 24 Volts. Pour alimenter chacun des dispositifs à leur tension de fonctionnement, ces appareils électriques comprennent plusieurs convertisseurs de tension pouvant délivrer chacun une basse tension convenant aux dispositifs auxquels ils sont associés.

Un inconvénient de ces appareils électriques vient du fait qu'ils nécessitent d'embarquer, outre un bloc d'alimentation général, plusieurs alimentations basse tension dédiées aux dispositifs dont il est équipé, contenus dans des boitiers présentant un volume non négligeable et agencés dans les appareils électriques au gré de l'espace disponible.

La configuration des alimentations basse tension est par ailleurs peu flexible à l'évolution de tels appareils électriques pour l'ajout ou le remplacement de nouveaux dispositifs présentant des tensions d'entrées différentes.

L'invention a pour objectif de pallier au moins l'un des inconvénients cités en proposant des alimentations basse tension peu encombrantes et adaptables à l'évolution des appareils électriques.

Pour cela, l'invention a pour objet, selon un premier aspect, un module de tension pour coffret de distribution de basse tension électrique, le module de tension comprenant : un boitier logeant :
une unité de conversion de tension DC-DC,
un moyen de dissipation thermique associé à l'unité de conversion de tension DC-DC. Le module est remarquable en ce que le boitier a une largeur égale à un multiple de deux pas, le multiple de deux pas étant compris entre deux pas et quarante-huit pas.

Le boitier peut présenter une largeur au moins égale à un multiple de deux pas, soit 18 millimètres, le multiple de deux pas étant compris entre deux pas et quarante-huit pas. Le module de tension selon l'invention permet une modularité des alimentations basse tension pouvant être simplement disposées sur un rail DIN pour former un coffret de distribution basse tension. De cette façon, la distribution d'alimentation basse tension dans l'appareil électrique qu'il équipe est simplifiée.

Par ailleurs, le module d'une telle largeur permet d'optimiser l'espace dans l'appareil qu'il équipe et contribue ainsi à réduire le dimensionnement du châssis de l'appareil. Préférentiellement, la largeur, ou le multiple de deux pas, est égal(e) à deux pas, quatre pas, huit pas, douze pas ou dix-huit pas.

Par exemple, pour deux pas la largeur du boitier est égale à 18 mm. Ou encore par exemple, pour quatre pas la largeur du boitier est égale à 36 mm.

L'épaisseur d'un module de tension correspond à la mesure de sa largeur prise dans une direction parallèle à la longueur d'un rail DIN sur lequel il est destiné à être assemblé.

Le module peut comprendre les caractéristiques suivantes, prises seules ou selon l'une quelconque de leurs combinaisons techniquement possibles.

L'unité de conversion de tension fournit un courant de sortie jusqu'à 5 Ampères.

La tension de sortie de l'unité de conversion de tension DC-DC est comprise entre 1 à 20 Volts.

La puissance maximale à fournir au module est préférentiellement de 100 Watts. L'unité de conversion de tension DC-DC comprend une carte d'électronique de puissance, et le moyen de dissipation thermique comprend au moins un complexe thermique, le complexe thermique couvrant au moins partiellement une face de la carte d'électronique de puissance.

Le complexe thermique est préférentiellement une pâte thermique.

L'utilisation d'un complexe thermique sur au moins une face de la carte d'électronique de puissance permet une répartition homogène de la dissipation de chaleur dégagée par la carte d'électronique de puissance.

Ledit complexe thermique prend une forme plane comprenant un ajour et une saillie, l'ajour étant prévu pour entourer une bobine de la carte d'électronique de puissance, et la saillie étant prévue pour être en correspondance d'un circuit de commande de la carte d'électronique de puissance.

La forme plane permet d'optimiser sur une grande surface la répartition homogène de la dissipation de chaleur dégagée par la carte d'électronique de puissance, alors que l'ajour vise à entourer le composant le plus dissipatif de chaleur de la carte d'électronique de puissance afin de mieux dissiper sa chaleur sur l'ensemble du complexe.

Le moyen de dissipation thermique comprend le complexe thermique, dit premier complexe thermique, associé à la face de la carte d'électronique de puissance, dite première face, et un deuxième complexe thermique,
ledit deuxième complexe thermique couvrant au moins partiellement une face de la carte d'électronique de puissance opposée à ladite première face.

L'association de deux complexes thermique sur chaque face de la carte d'électronique de puissance permet de favoriser sa dissipation thermique.

On comprendra que le ou des complexes sont disposés dans l'espace du boitier entre ses parois et la carte d'électronique de puissance.

L'unité de conversion de tension DC-DC comprend une entrée de tension et de commande prévue pour être reliée à une carte de relais de commande et de distribution de tension électrique du coffret de distribution de basse tension électrique. Préférentiellement, l'entrée de tension et de commande comprend une première série de broches de tension et une deuxième série de broches de commande.

Le module comprend une sortie de tension prévue pour alimenter un dispositif électrique.

Selon un deuxième aspect, l'invention concerne un autre module de tension pour coffret de distribution de basse tension électrique, où le module de tension est configuré pour fournir une tension de sortie égale à sa tension d'entrée, le module comprenant :
un boitier logeant une unité d'interruption et/ou de limitation du courant de sortie,
le module étant remarquable en ce que le boitier a une largeur égale à un multiple de deux pas, le multiple de deux pas étant compris entre deux pas et quarante-huit pas. Préférentiellement, la largeur ou le multiple de deux pas, est égal(e) à deux pas, quatre pas, huit pas, douze pas ou dix-huit pas.

Le module de tension peut comprendre un moyen de mesure du courant de sortie et un moyen d'interruption et/ou de limitation du courant de sortie lorsqu'une valeur du courant de sortie mesurée par le moyen de mesure est supérieure à une valeur seuil. Selon un troisième aspect, l'invention concerne un coffret de distribution de basse tension électrique, remarquable en ce qu'il comprend :
une pluralité de modules de tension tels que définis précédemment,
un rail DIN,
une carte de relais de commande et de distribution de tension électrique,
en entrée de chacun desdites modules,
la carte de relais de commande et de distribution de tension électrique étant prévue pour être fixée sur le rail et les modules de tension reliés à la carte de relais de commande et de distribution de tension électrique.

Le coffret peut comprendre les caractéristiques suivantes, prises seules ou selon l'une quelconque de leurs combinaisons techniquement possibles.

Le coffret comprend une feuille isolante électriquement, disposée entre le rail et la carte de relais de commande et de distribution de tension.

Le coffret comprend un module de pilotage des modules de tension, relié auxdits modules par l'intermédiaire de la carte de relais de commande et de distribution de tension.

Le module de pilotage comprend un moyen de pilotage configuré pour commander la mise hors ou sous tension de chacun des modules de tension individuellement.

Le module de pilotage comprend un microcontrôleur de type ARM 32 bits.

Le module de pilotage comprend un boîtier ayant une largeur égale à un multiple de deux pas, le multiple de deux pas étant compris entre deux pas et quarante-huit pas. Le module de pilotage comprend une fiche d'entrée de type USB, USB-C ou encore Ethernet.

L'utilisation d'une entrée de type USB ou USB-C permet la reprogrammation ou la mise à jour du module de pilotage. Lorsque l'entrée est de type USB-C ou Ethernet, il est possible d'assurer la télémaintenance du module de pilotage.

L'invention concerne également un boîtier pour modules de tension et/ou de pilotage tels que définis précédemment, le boîtier ayant une largeur égale à un multiple de deux pas, le multiple de deux pas étant compris entre deux pas et quarante-huit pas, le boîtier étant configuré pour comprendre individuellement ou en combinaison : au moins une unité de conversion de tension DC-DC, au moins un moyen de dissipation thermique associé à l'unité de conversion de tension DC-DC, au moins une unité d'interruption et/ou de limitation du courant de sortie, et au moins un moyen de pilotage.

Selon un autre aspect, l'invention comprend une borne interactive destinée à des usagers, comprenant un coffret de distribution de basse tension électrique tel que défini précédemment.

D'autres caractéristiques et avantages de l'invention apparaîtront à la lecture de la description nullement limitative qui suit et des figures annexées qui illustrent de manière schématique plusieurs modes de réalisation de l'invention.
La figure 1A représente une vue schématique d'un coffret de distribution basse tension alimentée par une source d'alimentation DC-DC et comprenant une pluralité de modules de tension.
La figure 1B représente une vue d'un coffret de distribution basse tension comportant un rail DIN équipé d'une pluralité de modules de tension.
La figure 2 représente un rail DIN, inclus dans le coffret de distribution, et équipé d'une carte de relais de commande et de distribution de tension électrique.
La figure 3 représente un module de tension dont le boîtier et le complexe thermique ont été retirés.

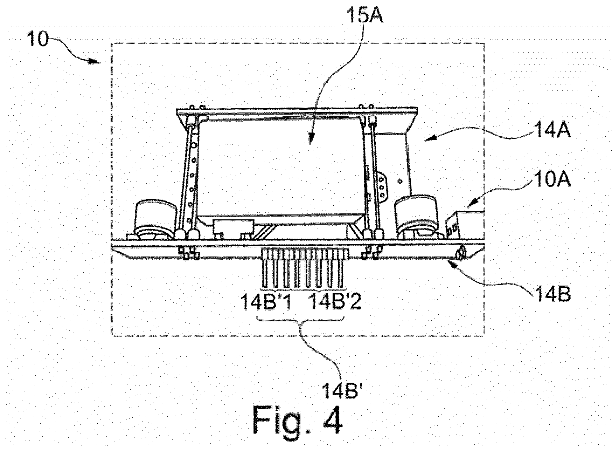

La figure 4 représente un module de tension équipé d'un complexe thermique.
La figure 5 représente le module de tension dans son boîtier.

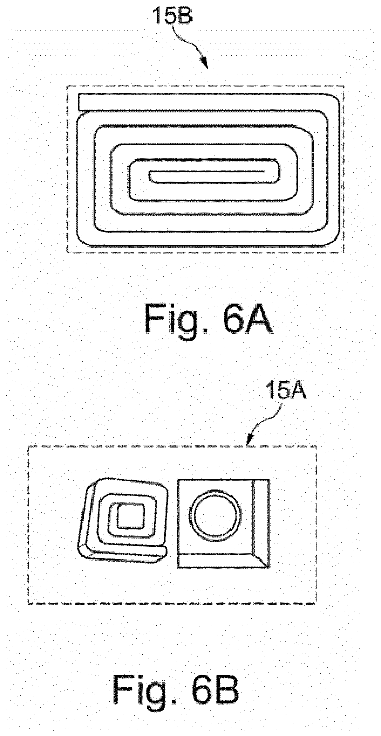

La figure 6A représente un premier complexe thermique.
La figure 6B représente un deuxième complexe thermique.

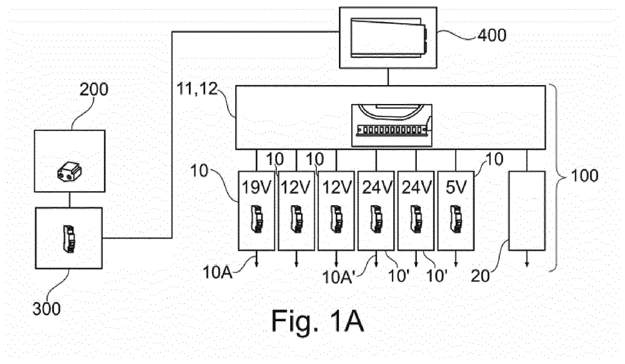

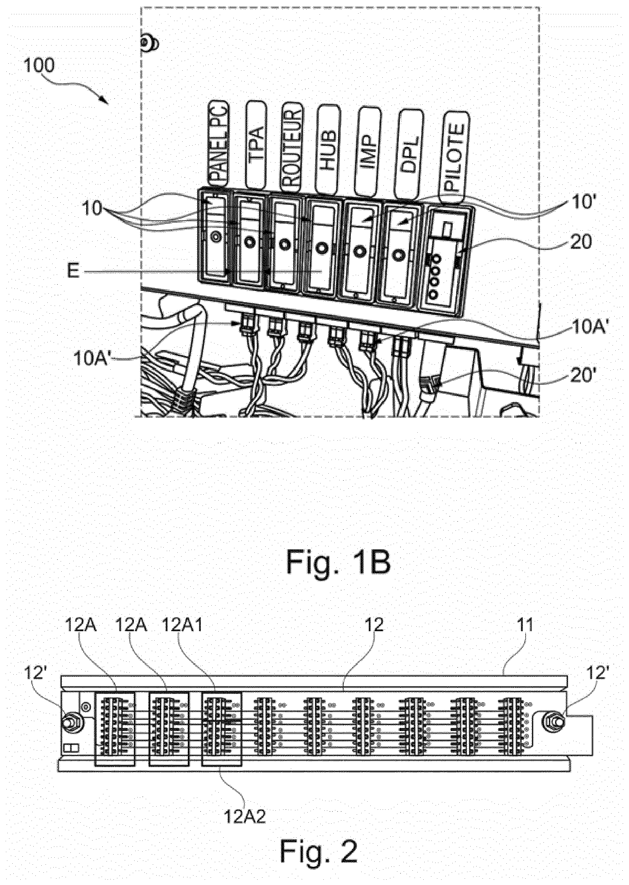

A la figure 1A, on a représenté une vue schématique d'un coffret 100 de distribution de basse tension électrique équipant une borne interactive, bien que l'invention ne soit pas limitée à une utilisation dans une borne interactive.

Une borne interactive ou tout autre appareil électrique assimilé comprend généralement un filtre secteur 200 relié à un disjoncteur 300. Par ailleurs, le disjoncteur 300 distribue une tension à une alimentation secondaire 400 prévue pour fournir en sortie une tension continu prédéterminée, ici 24 Volts.

L'alimentation secondaire 400 permet l'alimentation en tension d'entrée de chacun des modules de tension 10, 10' selon l'invention.

La distribution de tension depuis l'alimentation secondaire 400 vers les modules de tension 10, 10' est assurée par une carte 12 de relais de commande et de distribution de tension électrique tel que cela sera décrit ci-après.

Les modules de tension 10, 10' comprennent une sortie 10A, 10A' permettant de fournir une tension de sortie adaptée aux dispositifs qu'ils ont destinés à alimenter.

Tel que représenté à la figure 2, on a représenté un rail DIN 11 sous la forme d'un profilé formant support mécanique aux modules de tension 10, 10' destinés à y être fixés. Le rail DIN 11 présente un fond sur lequel est fixé la carte 12 de relais de commande et de distribution de tension électrique.

Bien que la forme du rail DIN 11 ne soit pas limitative, on préférera un rail DIN 11 de section en forme de chapeau, préférentiellement d'une largeur égale à 35 millimètres. La carte 12 de relais de commande et de distribution de tension électrique est avantageusement fixée au rail 11 par l'intermédiaire de moyens de fixation 12' prévus entre la carte 12 et le rail 11. Par exemple, des vis peuvent être prévues pour s'engager dans des ouvertures de la carte 12 et du rail 11 et fixées à l'aide d'un boulon.

La carte 12 de relais de commande et de distribution de tension électrique comprend une pluralité de fiches 12A de connexion, ici neuf fiches 12A, chacune prévues pour recevoir un module 10, 10'.

Chaque fiche 12A comprend une première paire de connecteurs 12A1 et une deuxième paire de connecteurs 12A2. La première paire de connecteurs 12A1 est destinée à l'alimentation électrique du module de tension 10, 10' correspondant, et la deuxième paire de connecteurs 12A2 est destinée à la commande du module de tension 10, 10' correspondant.

Ici la première paire de connecteurs 12A1 comprend six connecteurs dont : deux connecteur pouvant délivrée une tension de 24 Volts, chacun de ces connecteurs étant prévu pour un courant maximal de 3 Ampères ; deux premiers connecteurs de masse associés chacun à l'un des connecteurs délivrant 24 Volts ; et deux deuxièmes connecteurs de masse additionnels associés chacun à un des premiers connecteurs de masse afin de former une liaison équipotentielle assurant la continuité de masse et limitant les rayonnement électromagnétiques.

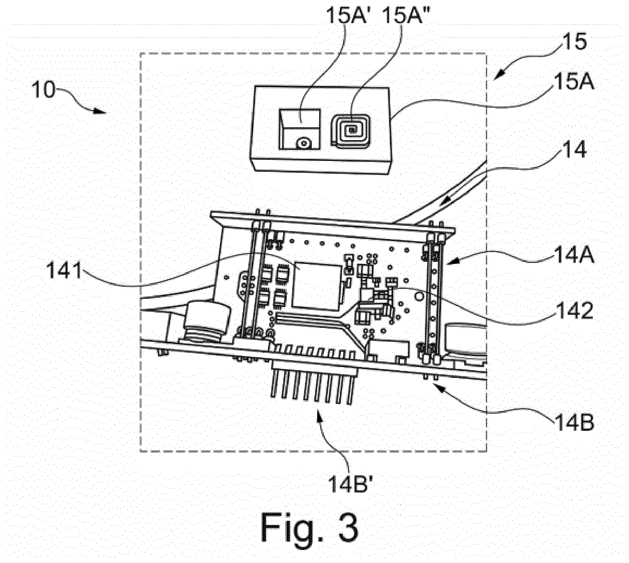

La deuxième paire de connecteurs 12A2 comprend 10 connecteurs chacun prévu pour la commande d'un module de tension 10, 10' identifié tel que cela sera décrit ci-après. A la figure 3, on a représenté un module de tension 10, 10' selon un premier aspect de l'invention sans son boîtier.

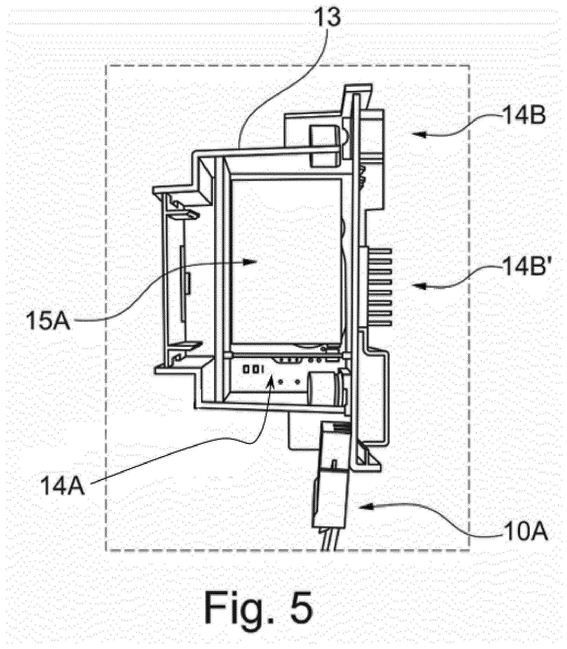

Le module de tension 10, 10' comprenant un boitier 13 (représenté à la figure 5) logeant une unité 14 de conversion de tension DC-DC, et un moyen de dissipation thermique 15 associé à l'unité 14 de conversion de tension DC-DC.

Le boitier présente une largeur égale à un multiple de deux pas, le multiple de deux pas étant compris entre deux pas et quarante-huit pas. Préférentiellement, la largeur ou le multiple de deux pas, est égal(e) à deux pas, quatre pas, huit pas, douze pas ou dix-huit pas. Le boitier peut ainsi présenter une largeur égale à deux pas, c'est à dire une largeur égale à 18 millimètres.

Chaque unité 14 de conversion de tension DC-DC peut fournir un courant de sortie allant jusqu'à 5 Ampères et la tension de sortie pouvant être fournit par l'unité 14 de conversion de tension DC-DC peut être de 20 Volts au maximum. Il en résulte que la puissance maximale d'un module est de 100 Watts.

L'unité 14 de conversion de tension DC-DC comprend une carte 14A d'électronique de puissance, et le moyen de dissipation thermique 15 comprend un premier complexe thermique 15A et un deuxième complexe thermique 15B couvrant au moins en partie chacun une face de la carte 14A d'électronique de puissance.

Chaque complexe thermique 15A, 15B prend une forme plane et il est formé par une pâte thermique permettant la dissipation de chaleur.

Le premier complexe thermique 15A est prévu pour être disposé sur la face de la carte 14A comprenant des composants de puissance que sont une bobine 141 et un circuit de commande 142.

A cet effet, ce premier complexe 15A comprend ajour borgne 15A' prévu pour entourer la bobine 141, et une saillie 15A" formant une excroissance de ce complexe afin de venir en appui contre le circuit de commande 142 de cette carte 14A d'électronique de puissance.

On notera que la bobine 141 est préférentiellement encapsulée pour ne pas émettre de rayonnements électromagnétiques.

Le deuxième complexe thermique 15B est uniforme et il est disposé sur la face de la carte 14A dépourvue de composant de puissance.

La combinaison des deux complexes 15A, 15B permet de prendre en sandwich la carte 14A d'électronique de puissance pour favoriser la dissipation de chaleur qu'elle dégage. Le ou les complexes thermiques 15A, 15B permettent la dissipation thermique de l'énergie thermique fournie par l'unité 14 de conversion de tension DC-DC contenue dans un module de tension 10, 10' d'une largeur (E) égale à deux pas.

L'unité 14 de conversion de tension DC-DC comprend par ailleurs une carte d'entrée 14B comprenant une entrée 14B' de tension et de commande prévue pour être reliée à la carte 12 de relais de commande et de distribution de tension électrique du coffret 100 de distribution de basse tension électrique.

L'entrée 14B' de tension et de commande comprend une première série de broches de tension 14B'1, ici 6 broches de tension, et une deuxième série de broches de commande 14B'2, ici 10 broches de commande.

La première série de broches de tension 14B'1 est destinée à être enfichée dans la première paire de connecteurs 12A1 de la carte 12 de relais de commande et de distribution de tension électrique, et la deuxième série de broches de commande 14B'2 est destinée à être enfichée dans la deuxième paire de connecteurs 12A2 de la carte 12 de relais de commande et de distribution de tension électrique.

Chaque module 10, 10' comprend en outre une sortie de tension prévue pour alimenter un dispositif électrique.

Selon un deuxième aspect de l'invention, un autre module de tension 10' selon l'invention est dépourvu de convertisseur de tension DC-DC puisqu'il est destiné à fournir une tension de sortie égale à sa tension d'entrée, le module comprenant :
un boitier 13 logeant une unité d'interruption et/ou de limitation du courant de sortie, le module étant remarquable en ce que le boitier a une largeur égale à un multiple de deux pas, le multiple de deux pas étant compris entre deux pas et quarante-huit pas.

Un tel autre module permet avantageusement de fournir un format de module de tension 10' standardisé avec d'autres modules de tension 10 selon l'invention comprenant des convertisseurs de tension.

Cet autre module 10' comprend également un moyen de mesure du courant de sortie, ici un amplificateur de mesure du courant de sortie, et un moyen d'interruption et/ou de limitation du courant de sortie, ici un transistor MOS de type P. le moyen d'interruption est prévu pour interrompre la tension de sortie de ce module 10' lorsqu'une valeur du courant de sortie mesurée par le moyen de mesure est supérieure à une valeur seuil, ici 6 Ampères. A cet effet, il est prévu un comparateur de courant. Le comparateur de courant est avantageusement relié à une entrée d'activation/désactivation d'un circuit de commande équipant ce module 10'. Lorsque la valeur du courant de sortie atteint la valeur seuil, un signal est émis par le comparateur sur l'entrée d'activation/désactivation du circuit de commande pour désactiver le circuit de commande. La tension de sortie est alors interrompue.

Le moyen d'interruption formé par le transistor de type P a avantageusement une capacité en courant égales au maximum à 55 Ampères.

Cet autre module de tension 10' comprend par ailleurs une entrée de tension et de commande comprend une première série de broches de tension 14B'1 et une deuxième série de broches de commande 14B'2, tel que décrit pour le module de tension 10, 10' selon le premier aspect de l'invention.

Outre les modules de tension 10, 10' décrits, le coffret 100 comprend un module de pilotage 20 des modules de tension 10, 10'. Le module de pilotage est relié auxdits modules par l'intermédiaire de la carte 12 de relais de commande et de distribution de tension.

A cet effet, le module de pilotage 20 comprend une entrée de tension comprenant une première série de broches de tension et une sortie de commande comprenant une deuxième série de broches de commande.

La première série de broches de tension et la deuxième série de broches de commande sont prévues pour être enfichées dans une des fiches 12A de la carte 12 de relais de commande et de distribution de tension, respectivement dans la première paire de connecteurs 12A1 et dans la première paire de connecteurs 12A1.

Ainsi, on comprendra que la deuxième série de broches de commande du module de pilotage est relié à la deuxième série de broches de commande 14B'2 de chaque module de tension 10, 10'.

Lorsqu'un module de tension 10, 10' est relié à la carte 12 de relais de commande et de distribution de tension, le module de pilotage 20 identifie la catégorie de module de tension 10, 10', en l'occurrence la tension de sortie qu'il est destiné à fournir en sortie pouvant être par exemple de 3.3 Volts, 5 volts, 9 Volts, 12 Volts, 19 Volts, ou encore 24 Volts.

Le module de pilotage 20 comprend un moyen de pilotage configuré pour commander la mise hors ou sous tension de chacun des modules de tension 10, 10' individuellement. En l'occurrence, les broches de commande 14B'2 des modules de tension 10, 10' sont prévues pour être reliées à une entrée d'activation/désactivation du circuit de commande de chaque module de tension 10, 10' pour activer/désactiver le circuit de commande. La tension en sortie du module de tension 10, 10' concernée est alors interrompue.

On comprendra que le module de pilotage 20 est prévu pour piloter le module de tension 10, 10' selon le premier aspect et selon le deuxième aspect.

Le module de pilotage 20 comprend une fiche d'entrée 20' de type USB, USB-C ou encore Ethernet.

Dans ce cas, l'entrée d'activation/désactivation du circuit de commande du module de tension 10, 10' selon le deuxième aspect reçoit deux entrées tel que défini ci-avant.

Bien évidemment, l'invention n'est pas limitée aux exemples qui viennent d'être décrits et de nombreux aménagements peuvent être apportés à ces exemples sans sortir du cadre de l'invention. Notamment, les différentes caractéristiques, formes, variantes et modes de réalisation de l'invention peuvent être associés les uns avec les autres selon diverses combinaisons dans la mesure où ils ne sont pas incompatibles ou exclusifs les uns des autres. En particulier, toutes les variantes et modes de réalisation décrits précédemment sont combinables entre eux.

## Revendications

1. Module de tension (10) pour coffret (100) de distribution de basse tension électrique, le module de tension (10) comprenant :
un boitier (13) logeant :
une unité (14) de conversion de tension DC-DC,
un moyen de dissipation (15A, 15B) thermique associé à l'unité (14), de conversion de tension DC-DC,
**caractérisé en ce que** le boitier (13) a une largeur (E) égale à un multiple de deux pas, le multiple de deux pas étant compris entre deux pas et quarante-huit pas.

2. Module de tension (10) selon la revendication précédente, **caractérisé en ce que** l'unité (14) de conversion de tension fournit un courant de sortie jusqu'à 5 Ampères.

3. Module de tension (10) selon l'une des revendications précédentes, **caractérisé en ce que** la tension de sortie de l'unité (14) de conversion de tension DC-DC est comprise entre 1 à 20 Volts.

4. Module de tension (10) selon l'une des revendications précédentes, **caractérisé en ce que** l'unité (14) de conversion de tension DC-DC comprend une carte (14A) d'électronique de puissance, et le moyen de dissipation (15A, 15B) thermique comprend au moins un complexe thermique (15A, 15B),
le complexe thermique couvrant au moins partiellement une face de la carte (14A) d'électronique de puissance.

5. Module de tension (10) selon la revendication précédente, **caractérisé en ce que** ledit complexe thermique (15A) prend une forme plane comprenant un ajour (15A') et une saillie (15A"),
l'ajour (15A') étant prévu pour entourer une bobine (141) de la carte (14A) d'électronique de puissance, et la saillie (15A") étant prévue pour être en correspondance d'un circuit de commande (142) de la carte (14A) d'électronique de puissance.

6. Module de tension (10) selon l'une des revendications 4 ou 5, **caractérisé en ce que** le moyen de dissipation (15A, 15B) thermique comprend le complexe thermique (15A), dit premier complexe thermique (15A), associé à la face de la carte (14A) d'électronique de puissance, dite première face, et un deuxième complexe thermique (15B),
ledit deuxième complexe thermique (15B) couvrant au moins partiellement une face de la carte (14A) d'électronique de puissance opposée à ladite première face.

7. Module de tension (10) selon l'une des revendications précédentes, **caractérisé en ce que** l'unité (14) de conversion de tension DC-DC comprend une entrée (14B') de tension et de commande prévue pour être reliée à une carte (12) de relais de commande et de distribution de tension électrique du coffret (100) de distribution de basse tension électrique.

8. Module de tension (10) selon l'une des revendications précédentes, **caractérisé en ce qu'**il comprend une sortie de tension (10A) prévue pour alimenter un dispositif électrique.

9. Module de tension (10') pour coffret (100) de distribution de basse tension électrique, le module de tension (10') est configuré pour fournir une tension de sortie égale à sa tension d'entrée, le module (10') comprenant :
un boitier (13) logeant :
une unité (14) d'interruption et de limitation du courant de sortie,
**caractérisé en ce que** le boitier (13) a une largeur (E) égale à un multiple de deux pas, le multiple de deux pas étant compris entre deux pas et quarante-huit pas.

10. Module de tension (10') selon la revendication précédente, **caractérisé en ce qu'**il comprend un moyen de mesure du courant de sortie et un moyen d'interruption du courant de sortie lorsqu'une valeur du courant de sortie mesurée par le moyen de mesure est supérieure à une valeur seuil.

11. Coffret (100) de distribution de basse tension électrique, **caractérisé en ce qu'**il comprend :
une pluralité de modules (10, 10') de tension selon l'une quelconque des revendications précédentes,
un rail DIN,
une carte (12) de relais de commande et de distribution de tension électrique en entrée de chacun desdites modules,
la carte (12) de relais de commande et de distribution de tension étant prévue pour être fixée sur le rail et les modules de tension (10, 10') reliés à la carte (12) de relais de commande et de distribution de tension électrique.

12. Coffret (100) de distribution de basse tension électrique selon la revendication précédente, **caractérisé en ce qu'**il comprend une feuille isolante électriquement, disposée entre le rail et la carte (12) de relais de commande et de distribution de tension.

13. Coffret (100) de distribution de basse tension électrique selon l'une des revendications 11 ou 12, **caractérisé en ce qu'**il comprend un module de pilotage (20) des modules de tension (10, 10'), relié auxdits modules par l'intermédiaire de la carte (12) de relais de commande et de distribution de tension.

14. Coffret (100) de distribution de basse tension électrique selon la revendication précédente, **caractérisé en ce que** le module de pilotage (20) comprend un moyen de pilotage configuré pour commander la mise hors ou sous tension de chacun des modules (10, 10') de tension individuellement.

15. Borne interactive destinée à des usagers, comprenant un coffret (100) de distribution de basse tension électrique selon l'une des revendications 11 à 14.
